# EUROPEAN PATENT APPLICATION

(11) **EP 4 431 484 A1**
(43) Date of publication of application: **18.09.2024**
(21) Application number: 23161843.0
(22) Date of filing: 14.03.2023
(51) Int. Cl.: C04B 37/00, C23C 14/00, C23C 16/16, H01L 21/48, H01L 23/15, H01L 23/373

(54) **A METHOD FOR FABRICATING A SEMICONDUCTOR MODULE COMPRISING A SUBSTRATE WITH AN INSULATING CERAMIC LAYER AND A SEMICONDUCTOR MODULE**

(71) Applicant: Infineon Technologies Austria AG, 9500 Villach (AT)
(72) Inventor: ROTH, Alexander, 93197 Zeitlarn (DE)
(74) Representative: Lambsdorff & Lange Patentanwälte Partnerschaft mbB

(57) **Abstract**

A semiconductor module (10; 20) comprises a first metal layer (11; 21), a ceramic layer (12; 22) applied on the first metal layer (11; 21), a second metal layer (13; 23) applied at least in part on the ceramic layer (12; 22), and a semiconductor die (14; 24) attached on a portion of the second metal layer (13; 23).

## Description

### TECHNICAL FIELD

The present disclosure is related to a method for fabricating a semiconductor module and to a semiconductor module.

### BACKGROUND

Power semiconductor modules usually comprise a multiplicity of controllable semiconductor components (e.g. semiconductor transistors like IGBTs, diodes and drivers) arranged on at least one substrate. The substrate generally comprises an electrically insulating substrate layer (e.g., a ceramic layer), a first electrically conductive layer (e.g., a metal layer) arranged on a first (upper) side of the substrate layer, and a second electrically conductive layer (e.g., a metal layer) arranged on a second (lower) side of the substrate layer opposite the first side. The controllable semiconductor components are arranged on the first electrically conductive layer, for example. The second electrically conductive layer is usually connected to a baseplate like a printed circuit board.

For the electrically insulating layer in many cases a ceramic layer is used. Current ceramic substrates in power modules and molded modules are limited in their performance by their current production process. Tape casting, for example, cannot produce ceramic substrates below 250pm thickness. In order to compensate, more and more expensive nitride ceramics have been designed in.

For these and other reasons there is a need for the present disclosure.

### SUMMARY

A first aspect of the present disclosure is related to a method for fabricating a semiconductor module, the method comprising providing a first metal layer, applying a ceramic layer by means of plasma enhanced chemical vapor deposition (PECVD) to the first metal layer, applying a second metal layer at least in part to the ceramic layer, and attaching a semiconductor die on a portion of the second metal layer.

According to an embodiment of the method according to the first aspect, a material of the ceramic layer comprises one or more of Si3N4, SiO or AlN, mixtures thereof or layerings thereof.

According to an embodiment of the method according to the first aspect, the method further comprises applying the ceramic layer to a thickness in a range from 10 µm to 40 µm, wherein the lower limit can also be 15 µm or 20 µm and the upper limit can also be 35 µm or 30 pm.

According to an embodiment of the method according to the first aspect, a thickness ratio of the ceramic layer to the first metal layer is at least 1:5 or 1:15.

According to an embodiment of the method according to the first aspect, the applied ceramic layer comprises a compressive stress in a range from 0,5 MPa to 20 MPa, wherein the lower limit can also be 1 MPa, 2 MPa, 4 MPa, 6 MPa, 8 MPa, or 10 MPa, and the upper limit can also be 18 MPa, 16 MPa, 14 MPa, or 12 MPa.

According to an embodiment of the method according to the first aspect, the applied ceramic layer comprises a thermal resistance of less than 13 K/W based on a one mm² reference area.

According to an embodiment of the method according to the first aspect, the method further comprises applying the ceramic layer by using a process temperature of the PECVD of below 400°C or below 350°C or below 300°C or below 250°C or below 200°C or below 150°C or below 100°C.

According to an embodiment of the method according to the first aspect, the PECVD can be either magPECVD comprising a dynamic deposition rate in a range between 100 m/min and 500 m/min, or arcPECVD comprising a dynamic deposition rate in a range between 200 m/min and 3000 m/min. The dynamic deposition rate is the product of film thickness and the substrate velocity divided by the number of cycles in a roll-to-roll process.

An advantage of the PECVD technology is that it can be performed below 400°C because the plasma provides the energy for ions. Otherwise, the PECVD process can be performed in the classical and conventional way, i.e., using NH3 and silane (SiH4) with N2 as carrier gas, with an RF power of typically 60W. The process temperature should be below 400°C, preferably below 250°C, but not below an expected operating temperature of the semiconductor module to preserve the compressive stress of the ceramic layer over the operating range of the semiconductor module.

According to an embodiment of the method according to the first aspect, the method further comprises applying the second metal layer to a thickness in a range from 10 µm to 120 µm wherein the lower limit can also be 20 pm, 30 pm, 40 µm or 50 µm and the upper limit can also be 110 pm, 100 pm, 90 µm or 80 µm.

According to an embodiment of the method according to the first aspect, the method further comprises applying the second metal layer by means of plasma enhanced chemical vapor deposition or by sputtering. The second metal layer can, for example, be deposited at a process temperature below the process temperature of the PECVD deposition of the ceramic layer in order to prevent the occurrence of cracks.

According to an embodiment of the method according to the first aspect, the semiconductor die comprises one or more of a power semiconductor transistor, an IGBT, a MOSFET, a diode, or a driver device.

A second aspect of the present disclosure is related to a semiconductor module, comprising a first metal layer, a ceramic layer applied on the first metal layer, a second metal layer applied at least in part on the ceramic layer, and a semiconductor die attached on a portion of the second metal layer.

According to an embodiment of the semiconductor module according to the second aspect, a material of the ceramic layer comprises one or more of Si3N4, SiO or AlN, Zirconia doped alumina, ZrO, SiAlON or mixtures thereof or layerings thereof.

According to an embodiment of the semiconductor module according to the second aspect, the ceramic layer comprises a thickness in a range from 10 µm to 40 µm, wherein the lower limit can also be 15 µm or 20 µm and the upper limit can also be 35 µm or 30 µm.

According to an embodiment of the semiconductor module according to the second aspect, the first metal layer can, for example, be made of or comprise copper or a copper alloy and can have a thickness in a range from 50 µm to 600 µm, wherein the lower limit can also be 100 pm, 150 pm, 200 pm, 250 pm, or 300 µm, and the upper limit can also be 550 pm, 500 pm, 450 pm, or 400 µm.

According to an embodiment of the semiconductor module according to the second aspect, the first metal layer can also have a thickness so that a thickness ratio of the ceramic layer to the first metal layer is at least 1:5 or 1:15.

According to an embodiment of the semiconductor module according to the second aspect, the ceramic layer comprises a compressive stress in a range from 0,5 MPa to 20 MPa wherein the lower limit can also be 1 MPa, 2 MPa, 4 MPa, 6 MPa, 8 MPa, or 10 MPa, and the upper limit can also be 18 MPa, 16 MPa, 14 MPa, or 12 MPa.

According to an embodiment of the semiconductor module according to the second aspect, the ceramic layer comprises a thermal resistance less of than 13 K/W based on a one mm² reference area.

According to an embodiment of the semiconductor module according to the second aspect, the second metal layer comprises a thickness in a range from 10 µm to 120 pm, wherein the lower limit can also be 20 pm, 30 pm, 40 µm or 50 µm and the upper limit can also be 110 pm, 100 pm, 90 µm or 80 µm.

According to an embodiment of the semiconductor module according to the second aspect, the semiconductor die comprises one or more of a power semiconductor transistor, an IGBT, a MOSFET, a diode, or a driver device.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows a cross-sectional side view on an example of a semiconductor module according to the second aspect comprising a first metal layer made of copper.
Fig. 2 shows a cross-sectional side view on an example of a semiconductor module according to the second aspect comprising a first metal layer made of aluminum and comprising a recess for inserting a water cooler.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

Moreover, the word "exemplary" is used herein to mean serving as an example, instance, or illustration. Any aspect or design described herein as "exemplary" is not necessarily to be construed as advantageous over other aspects or designs. Rather, use of the word exemplary is intended to present concepts in a concrete fashion. As used in this application, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims may generally be construed to mean "one or multiple" unless specified otherwise or clear from context to be directed to a singular form. Also, at least one of A and B or the like generally means A or B or both A and B.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

### DETAILED DESCRIPTION

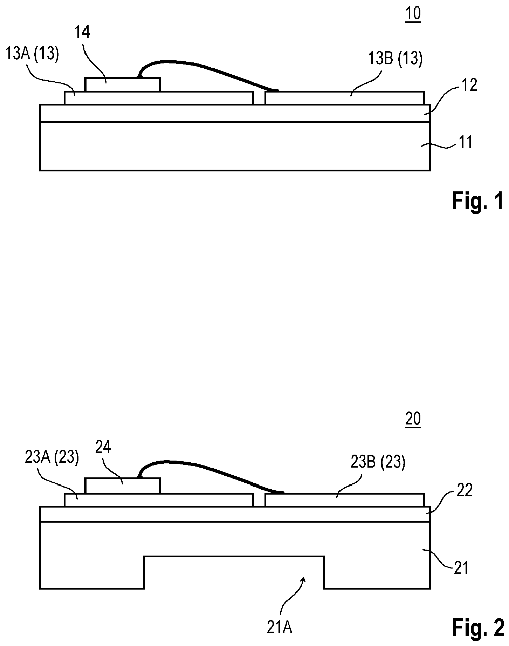

Fig. 1 shows a cross-sectional side view on an example of a semiconductor module according to the second aspect comprising a first metal layer made e.g. of copper.

More specifically, Fig. 1 shows a semiconductor module 10 comprising a first metal layer 11, a ceramic layer 12 applied on the first metal layer 11, a second metal layer 13 applied at least in part on the ceramic layer 12, and a semiconductor die 14 attached on a portion of the second metal layer 13.

The second metal layer 13 can comprises a first layer portion 13A and a second layer portion 13B and the semiconductor die 14 can applied on the first layer portion 13A.

The semiconductor die 14 can be a semiconductor transistor die 14, in particular a power semiconductor transistor die 14. Here, the term "power semiconductor transistor die" may refer to a semiconductor die providing at least one of high voltage blocking or high current-carrying capabilities. A power semiconductor die may be configured for high currents having a maximum current value of a few Amperes, such as e.g. 10 A, or a maximum current value of up to or even exceeding 100 A. Similarly, voltages associated with such current values may have values of a few Volts to a few tens or hundreds or even thousands of Volts.

In the example shown in Fig. 1, the semiconductor die 14 can be one or more of a semiconductor transistor die, a power semiconductor transistor die, an IGBT, or a MOSFET. However, as already mentioned before, the semiconductor die 14 can also be another die like a diode die or a driver die.

Furthermore the semiconductor die 14 as described herein may be manufactured from an elemental semiconductor material (e.g. Si) or from a wide band gap semiconductor material or a compound semiconductor material (e.g. SiC, GaN, SiGe, GaAs).

The first metal layer 11 can, for example, be made of or comprise copper or a copper alloy and can have a thickness in a range from 50 µm to 600 µm depending on the thickness of the ceramic layer and the preferred thickness ratio between both layers.

The ceramic layer 12 can be made of or comprise Si3N4, SiO or AlN, Zirconia doped alumina, ZrO, SiAlON or mixtures thereof or layerings thereof and can have a thickness in a range from 10 µm to 40 µm.

The relative thicknesses of the first metal layer 11 and the ceramic layer 12 can also be adjusted so that a thickness ratio of the ceramic layer 12 to the first metal layer 11 is at least 1:5 or 1:15. Such a thick first metal layer 11 provides both the heatspreading as well as the compressive stress for the thin ceramic layer 12. A compressive stress can be generated in the ceramic layer 12 which can be in a range from 0,5 MPa to 20 MPa.

The ceramic layer 12 is deposited on the first metal layer 11 by PECVD as was described before at process temperatures below 400°C.

Both the thickness ratio between the ceramic layer 12 and the first metal layer 11 and the low process temperature of the PECVD deposition process lead to the compressive stress within the ceramic layer 12 with which bowing of the semiconductor module 10 can be prevented or at least be kept within acceptable limits.

The second metal layer 13 can have a thickness in a range from 10 µm to 120 µm. In this respect it is important to note that the current carrying capacity for power connections results mostly from wide traces within an aspect ratio width to thickness of the traces of 10:1 or more.

In a further embodiment of the semiconductor module 10 shown in Fig. 1, a heat sink can be attached to the backside of the first metallic layer 11 either by the manufacturer or by the customer and thermally coupled to the first metallic layer via a thermal interface layer.

Fig. 2 shows a cross-sectional side view on an example of a semiconductor module according to the second aspect comprising a first metal layer made of aluminum and comprising a recess for inserting a water cooler.

More specifically, Fig. 2 shows a semiconductor module 20 comprising a first metal layer 21, a ceramic layer 22 applied on the first metal layer 21, a second metal layer 23 applied at least in part on the ceramic layer 22, and a semiconductor die 24 attached on a portion of the second metal layer 23.

The above statements regarding some of the individual devices and layers of the semiconductor module 10 shown in Fig. 1 may apply in the same manner to the semiconductor module 20 of Fig. 2. In this sense, the ceramic layer 22 may correspond to the ceramic layer 12, the second metallic layer 23 may correspond to the second metallic layer 13, and the semiconductor die 24 may correspond to the semiconductor die 14.

Deviating from the embodiment shown in Fig. 1, the semiconductor module 20 of Fig. 2 has a first metallic layer 21, which has a recess 21A on its rear side. A water cooling system can be suitably integrated into this recess 21, which is connected to a cooling circuit, for example. The first metallic layer 21 is therefore preferably made of aluminum instead of copper, since aluminum is in general easier to machine than copper with regard to the shaping of the recess 21A.

It should also be mentioned that the semiconductor modules shown in Figs. 1 and 2 can be provided with a suitable encapsulant, which is usually a molding compound comprising a polymer such as an epoxy resin. This can be applied in such a way that the respective backsides of the first metallic layers 11 and 21 remain uncovered to enable heat dissipation by means of a heat sink or water cooling in the finished product.

### EXAMPLES

In the following specific examples of the present disclosure are described.

Example 1 is a method for fabricating a semiconductor module, the method comprising providing a first metal layer, applying a ceramic layer by means of plasma enhanced chemical vapor deposition to the first metal layer, applying a second metal layer at least in part to the ceramic layer, and attaching a semiconductor die on a portion of the second metal layer.

Example 2 is the method according to Example 1, wherein a material of the ceramic layer comprises one or more of Si3N4, SiO or AlN, Zirconia doped alumina, ZrO, SiAlON or mixtures thereof or layerings thereof.

Example 3 is the method according to Example 1 or 2, further comprising applying the ceramic layer to a thickness in a range from 10 µm to 40 µm.

Example 4 is the method according to any one of the preceding Examples, wherein a thickness ratio of the ceramic layer to the first metal layer is at least 1:5 or 1:15.

Example 5 is the method according to any one of the preceding Examples, wherein the applied ceramic layer comprises a compressive stress in a range from 0,5 MPa to 20 MPa.

Example 6 is the method according to any one of the preceding Examples, wherein the applied ceramic layer comprises a thermal resistance of less than 13 K/W based on a one mm² reference area.

Example 7 is the method according to any one of the preceding Examples, further comprising applying the ceramic layer by using a process temperature of the plasma enhanced chemical vapor deposition of below 400°C or below 350°C or below 300°C or below 250°C.

Example 8 is the method according to any one of the preceding Examples, further comprising applying the second metal layer to a thickness in a range from 10 µm to 120 µm.

Example 9 is the method according to any one of the preceding Examples, further comprising applying the second metal layer by means of plasma enhanced chemical vapor deposition or by sputtering.

Example 10 is the method according to any one of the preceding Examples, wherein the semiconductor die comprises one or more of a semiconductor transistor die, a power semiconductor transistor die, an IGBT, a MOSFET, a diode die, or a driver die.

Example 11 is a semiconductor module, comprising a first metal layer, a ceramic layer applied on the first metal layer, a second metal layer applied at least in part on the ceramic layer, and a semiconductor die attached on a portion of the second metal layer.

Example 12 is the semiconductor module according to Example 11, wherein a material of the ceramic layer comprises one or more of Si3N4, SiO or AlN, Zirconia doped alumina, ZrO, SiAlON or mixtures thereof or layerings thereof.

Example 13 is the semiconductor module according to Example 11 or 12, wherein the ceramic layer comprises a thickness in a range from 10 µm to 40 µm.

Example 14 is the semiconductor module according to any one of Examples 11 to 13, wherein the first metal layer so that a thickness ratio of the ceramic layer to the first metal layer is at least 1:5 or 1:15.

Example 15 is the semiconductor module according to any one of Examples 11 to 14, wherein the ceramic layer comprises a compressive stress in a range from 0,5 MPa to 20 MPa.

Example 16 is the semiconductor module according to any one of Examples 11 to 15, wherein the ceramic layer comprises a thermal resistance less of than 13 K/W based on a one mm² reference area.

Example 17 is the semiconductor module according to any one of Examples 11 to 16, wherein the second metal layer comprises a thickness in a range from 10 µm to 120 µm.

Example 18 is the semiconductor module according to any one of Examples 11 to 17, wherein the semiconductor die comprises one or more of a semiconductor transistor die, a power semiconductor transistor die, an IGBT, a MOSFET, a diode die, or a driver die.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A method for fabricating a semiconductor module, the method comprising
- providing a first metal layer;
- applying a ceramic layer by means of plasma enhanced chemical vapor deposition to the first metal layer;
- applying a second metal layer at least in part to the ceramic layer; and
- attaching a semiconductor die on a portion of the second metal layer.

2. The method according to claim 1, wherein
a material of the ceramic layer comprises one or more of Si3N4, SiO or AlN, Zirconia doped alumina, ZrO, SiAlON or mixtures thereof or layerings thereof.

3. The method according to claim 1 or 2, further comprising applying the ceramic layer to a thickness in a range from 10 µm to 40 µm.

4. The method according to any one of the preceding claims, wherein
a thickness ratio of the ceramic layer to the first metal layer is at least 1:5 or 1:15.

5. The method according to any one of the preceding claims, wherein
the applied ceramic layer comprises a compressive stress in a range from 0,5 MPa to 20 MPa.

6. The method according to any one of the preceding claims, wherein
the applied ceramic layer comprises a thermal resistance of less than 13 K/W based on a one mm² reference area.

7. The method according to any one of the preceding claims, further comprising
applying the ceramic layer by using a process temperature of the plasma enhanced chemical vapor deposition of below 400°C or below 350°C or below 300°C or below 250°C or below .

8. The method according to any one of the preceding claims, further comprising
applying the second metal layer to a thickness in a range from 10 µm to 120 µm.

9. The method according to any one of the preceding claims, further comprising
applying the second metal layer by means of plasma enhanced chemical vapor deposition or by sputtering.

10. The method according to any one of the preceding claims, wherein
the semiconductor die comprises one or more of a semiconductor transistor die, a power semiconductor transistor die, an IGBT, a MOSFET, a diode die, or a driver die.

11. A semiconductor module (10; 20), comprising
- a first metal layer (11; 21);
- a ceramic layer (12; 22) applied on the first metal layer (11; 21);
- a second metal layer (13; 23) applied at least in part on the ceramic layer (12; 22); and
- a semiconductor die (14; 24) attached on a portion of the second metal layer (13; 23).

12. The semiconductor module (10; 20) according to claim 11, wherein
a material of the ceramic layer (12; 22) comprises one or more of Si3N4, SiO or AlN, Zirconia doped alumina, ZrO, SiAlON or mixtures thereof or layerings thereof.

13. The semiconductor module (10; 20) according to claim 11 or 12, wherein
the ceramic layer (12; 22) comprises a thickness in a range from 10 µm to 40 µm.

14. The semiconductor module (10; 20) according to any one of claims 11 to 13, wherein
the first metal layer (11; 21);
so that a thickness ratio of the ceramic layer to the first metal layer is at least 1:5 or 1:15.

15. The semiconductor module (10; 20) according to any one of claims 11 to 14, wherein
the ceramic layer (12; 22) comprises a compressive stress in a range from 0,5 MPa to 20 MPa.

16. The semiconductor module (10; 20) according to any one of claims 11 to 15, wherein
the ceramic layer (12; 22) comprises a thermal resistance less of than 13 K/W based on a one mm² reference area.

17. The semiconductor module (10; 20) according to any one of claims 11 to 16, wherein
the second metal layer second metal layer (13; 23) comprises a thickness in a range from 10 µm to 120 µm.

18. The semiconductor module (10; 20) according to any one of claims 11 to 17, wherein
the semiconductor die (14; 24) comprises one or more of a semiconductor transistor die, a power semiconductor transistor die, an IGBT, a MOSFET, a diode die, or a driver die.
